# EUROPEAN PATENT APPLICATION

(11) **EP 4 092 562 A2**
(43) Date of publication of application: **23.11.2022**
(21) Application number: 22171309.2
(22) Date of filing: 03.05.2022
(51) Int. Cl.: G06F 30/3308, H04L 41/14

(54) **NETWORK SIMULATOR, NETWORK SIMULATION METHOD, AND NETWORK SIMULATION PROGRAM**

(30) Priority: 19.05.2021 JP 2021084873
(71) Applicant: Yokogawa Electric Corporation, Musashino-shi, Tokyo 180-8750 (JP)
(72) Inventor: ENOMOTO, Hiroya, Musashino-shi, Tokyo, 180-8750 (JP); HONGO, Takeshi, Musashino-shi, Tokyo, 180-8750 (JP); NAKAJIMA, Hiroaki, Musashino-shi, Tokyo, 180-8750 (JP)
(74) Representative: Hoffmann Eitle

(57) **Abstract**

Provided is acquiring communication information (75a) via communication or directly from an engineering DB (corresponding to one example "database") (51) in which the communication information related to communication devices constituting a plant network (PN) is defined; storing the acquired communication information (75a); calculating, based on the stored communication information (75a), a total communication amount of each of the communication devices supposed in communication executed in corresponding one of the communication devices; estimating, based on the total communication amount, an actual communication amount of each of the communication devices according to an arbitrary estimation condition specified by a user; determining at least presence/absence of a communication device whose actual communication amount exceeds communication capability of the communication device; and outputting a determined determination result to the user.

## Description

### BACKGROUND OF THE INVENTION

### 1. Field of the Invention

Exemplary embodiments disclosed herein relate to a network simulator, a network simulation method, and a network simulation program.

### 2. Description of the Related Art

Conventionally, there has been proposed a technology that simulates traffic forwarding and setting processes between communication devices constituting a communication network in order to assist construction of the communication network and the like (see Japanese Patent No. 5750175, for example).

However, the conventional technology has room for improvement in effectively assisting construction of plant networks in various plants using petroleum, petrochemistry, chemistry, gas, and the like.

Conventionally, there has been a current situation that the design depending on past experience and knowledge of a designer is performed on a plant network. Thus, there has been a problem that whether or not the design is appropriate is hardly recognized in advance. Furthermore, there has presented no tool and the like, which is useful for the above-mentioned recognition in advance.

Note that in this point, the above-mentioned conventional technology is no more than a technology in which a network provider simulates traffic forwarding and/or a setting process in a communication network including a transfer node and a transmission node so as not to generate a transfer loop.

One aspect of the present disclosure is made in view of the aforementioned, and an object of the present disclosure is to provide a network simulator, a network simulation method, and a network simulation program capable of effectively assisting construction of a plant network.

### SUMMARY OF THE INVENTION

A network simulator according to one aspect of embodiments including: an acquisition unit that acquires communication information via communication or directly from a database in which the communication information related to communication devices constituting a plant network is defined; a storage that stores therein the communication information acquired by the acquisition unit; a calculation unit that calculates, based on the communication information stored in the storage, a total communication amount of each of the communication devices supposed in communication executed in corresponding one of the communication devices; an estimation unit that estimates, based on the total communication amount, an actual communication amount of each of the communication devices according to an arbitrary estimation condition specified by a user; a determination unit that determines at least presence/absence of a communication device whose actual communication amount exceeds communication capability of the communication device; and an output controlling unit that outputs a determination result determined by the determination unit to the user.

A network simulation method according to one aspect of embodiments of a process executed by a computer, the process including: acquiring communication information via communication or directly from a database in which the communication information related to communication devices constituting a plant network is defined; storing the acquired communication information; calculating, based on the stored communication information, a total communication amount of each of the communication devices supposed in communication executed in corresponding one of the communication devices; estimating, based on the total communication amount, an actual communication amount of each of the communication devices according to an arbitrary estimation condition specified by a user; determining at least presence/absence of a communication device whose actual communication amount exceeds communication capability of the communication device; and outputting a determined determination result to the user.

A network simulation program according to one aspect of embodiments, which causes a computer to execute a process including: acquiring communication information via communication or directly from a database in which the communication information related to communication devices constituting a plant network is defined; storing the acquired communication information; calculating, based on the stored communication information, a total communication amount of each of the communication devices supposed in communication executed in corresponding one of the communication devices; estimating, based on the total communication amount, an actual communication amount of each of the communication devices according to an arbitrary estimation condition specified by a user; determining at least presence/absence of a communication device whose actual communication amount exceeds communication capability of the communication device; and outputting a determined determination result to the user.

According to one aspect of embodiments, it is possible to provide a network simulator, a network simulation method, and a network simulation program capable of effectively assisting construction of a plant network.

### BRIEF DESCRIPTION OF THE DRAWINGS

FIG. 1 is a diagram illustrating an overall configuration example of a plant controlling system;
FIG. 2 is a diagram illustrating the outline of a network simulation method according to an embodiment;
FIG. 3 is a diagram illustrating one example of communication information;
FIG. 4 is a block diagram illustrating a configuration example of a network simulator;
FIG. 5 is a diagram illustrating a displaying example of a simulation result screen;
FIG. 6 is a diagram illustrating a displaying example of a simulation result screen;
FIG. 7 is a diagram illustrating a displaying example of a simulation result screen;
FIG. 8 is a diagram illustrating a displaying example of a simulation result screen;
FIG. 9 is a flowchart illustrating a processing procedure to be executed by the network simulator; and
FIG. 10 is a diagram illustrating a hardware configuration of one example of a computer configured to realize functions of the network simulator.

### DETAILED DESCRIPTION OF THE PREFERRED EMBODIMENTS

Hereinafter, embodiments of a network simulator, a network simulation method, and a network simulation program will be described in detail with reference to the accompanying drawings. Moreover, the disclosed technology is not limited to the embodiments described below. The same elements are provided with the respective same reference symbols, duplicated explanation is appropriately omitted, and the embodiments may be appropriately combined within a consistent range.

Hereinafter, in a case where there presents need for differentiating the plurality of same configuration elements, numbers are provided to the same reference symbols in the form of "-n" ("n" is natural number).

### Overall Configuration Example According to Present Embodiment

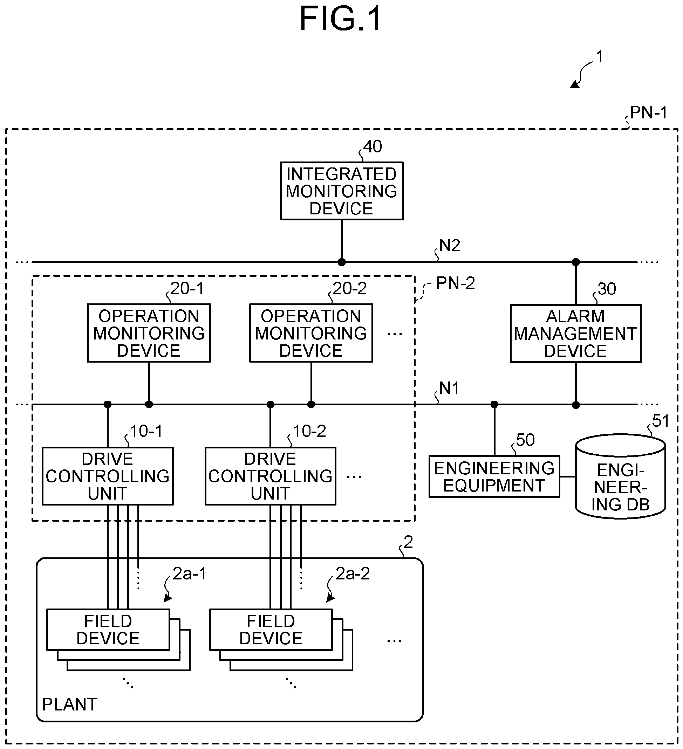

First, an overall configuration example of a plant controlling system 1 according to an embodiment will be explained. FIG. 1 is a diagram illustrating an overall configuration example of the plant controlling system 1 according to the embodiment. The plant controlling system 1 is a plant system that is used in executing operation control and monitoring on a plant 2, and includes a plant network PN. The plant network PN indicates all or a part of connections and communications that are realized by a communication infrastructure in the plant controlling system 1 or a communication infrastructure. In FIG. 1, there are illustrated whole plant network PN-1 and a modularized partial plant network PN-2. Note that FIG. 1 illustrates all or a part of the plant network PN for convenience of explanation, and thus is not intended to limit a configuration of the plant network PN.

The plant 2 is one example of various plants using petroleum, petrochemistry, chemistry, gas, and the like; and includes a plant provided with various facilities for obtaining products and the like. Examples of the products are Liquefied Natural Gas (LNG), resin (for example, plastic or nylon), chemical products, and the like. Examples of the facilities include a plant facility, a machine facility, a manufacturing facility, a power generation facility, a storage facility, a facility located in a well site where drilling for petroleum, liquefied natural gas, or the like is performed, and the like.

The plant 2 includes therein various devices for generating products, a plurality of field devices 2a-1, 2a-2... that acquire information related to states in the plant 2, and the like.

The field devices 2a, such as sensors, are devices that are set in various positions in the plant 2. The field devices 2a are roughly classified into a sensor device and an operation device, for example. The sensor device is a device that acquires (for example, detects or measures) physical quantity, for example. Examples of the sensor devices include a pressure sensor, a temperature sensor, a pH sensor, a velocity sensor, an acceleration sensor, and the like. The operation device is a device that operates physical quantity, for example. Examples of the operation devices include a valve, a pump, a fan, and the like; and are driven by a motor, an actuator, and the like.

The plant controlling system 1 is constituted of a plurality of communication devices including the field devices 2a. As illustrated in FIG. 1, the plant controlling system 1 includes as communication devices, in addition to the field devices 2a, drive controlling units 10, operation monitoring devices 20, an alarm management device 30, an integrated monitoring device 40, and an engineering equipment 50.

The field devices 2a and the drive controlling units 10 are connected to be able to communicate with each other via a field bus and the like. The drive controlling units 10, the operation monitoring devices 20, and the alarm management device 30 are connected to be able to communicate with each other via a network N1. The alarm management device 30 and the integrated monitoring device 40 are connected to be able to communicate with each other via a network N2.

The engineering equipment 50 is connected, via the network N1 or the network N2, to the drive controlling units 10, the operation monitoring devices 20, the alarm management device 30, and the integrated monitoring device 40 to be able to communicate with each other. In the example illustrated in FIG. 1, a case is exemplified where the engineering equipment 50 is connected to the network N1.

A dedicatedly-configured control bus may be employed for the network N1, for example. Data transmitted and received by the network N1 is data related to the plant 2, and includes data for controlling the plant 2 and the like. The controlling may include real-time controlling. In this meaning, it is very important to prevent abnormality in the network N1, such as missing in transmitted data.

Therefore, for example, the network N1 is duplicated from a viewpoint of improvement in the reliability and the like. In a case of the duplication, the network N1 may transmit and receive in parallel the same data by using two communication paths. In this case, even if an abnormality and the like occurs in one of the communication paths, transmission (sending and receiving) of data is maintained in the other communication path. As the network N1 like this, Vnet/IP (Registered Trademark) and the like may be used. A Local Area Network (LAN) and the like may be used as the network N2. The network N2 may be also duplicated from a viewpoint of improvement in the reliability and the like.

Note that FIG. 1 does not limitedly illustrates a physical configuration. Therefore, network topology of the plant network PN is not limited to a bus-type that is illustrated in FIG. 1. For example, the alarm management device 30, the integrated monitoring device 40, and the like may be present in the same machine. In this case, with respect to the above-mentioned intercommunication, intercommunication with the use of internal communication is executed.

The drive controlling unit 10 is a device that collects data from the field device 2a, and executes process controlling by using the collected data as process data. As one example of the process controlling, the drive controlling unit 10 basically executes Proportional-Integral-Differential Controller (PID controller).

Each of the drive controlling units 10 is generally configured as dedicated hardware to which the corresponding field device 2a is connected; however, at least a part of functions of a so-called Advanced Process Control server (APC server), which is configured as a general PC server, operates on the corresponding drive controlling unit 10 in some cases. In this case, as one example of process controlling, the drive controlling units 10 are capable of optionally executing advanced controlling (APC) on the plant 2 with the use of a control value that is used in controlling the plant 2 or a process value indicating an operation situation of the plant 2.

As illustrated in FIG. 1, in a case where the plurality of drive controlling units 10 is provided, the plant controlling system 1 constitutes a Distributed Control System (DCS) by using the drive controlling units 10.

The drive controlling unit 10 executes transmission and reception of data according to a standard for executing drive control on the plant 2 via a not-illustrated Open Platform Communications server (OPC server), an original interface, another interface, or the like.

Moreover, in a case where detecting an abnormality in a process data value, an abnormality in communication of the field device 2a, an abnormality in hardware, or the like; the drive controlling unit 10 informs the operation monitoring device 20 and/or the alarm management device 30 of an alarm.

The operation monitoring devices 20 are devices for operating/monitoring the plant 2. The operation monitoring devices 20 display various kinds of information related to the plant 2 so as to cause an operator to monitor operation of each of the field devices 2a, situations of various processes, and the like.

The operation monitoring devices 20 display, for example, graphic screens, trend screens and the like as various kinds of information related to the plant 2. The graphic screen is a screen obtained by converting operations and states of the field devices 2a and the like into a Graphical User Interface (GUI). A trend screen is a screen that displays time-series change, statistics such as a maximum value, a minimum value, and an average value, and real-time values of process data values.

The plurality of graphic screens and the plurality of trend screens are able to be expanded on a display of the operation monitoring device 20. In order to display a graphic screen and/or a trend screen, the operation monitoring device 20 transmits, to the drive controlling unit 10, a communication request for acquiring various kinds of information needed for generating the screens.

The operation monitoring device 20 receives, from an operator, a desired operating instruction for each of the field devices 2a, and informs the drive controlling unit 10 of the received operating instruction. The drive controlling unit 10 controls the field device 2a on the basis of the received operating instruction.

The alarm management device 30 is a device that provides function to be the core of alarm monitoring. When receiving information on alarm from the drive controlling unit 10, the alarm management device 30 controls a transition state of alarm in accordance with alarm definition information obtained by preliminarily defining behavior of alarm such as appearance of alarm, operation authority to check and the like, a monitoring range of each operator. Furthermore, the alarm management device 30 informs the integrated monitoring device 40 of the fact that a state of alarm has transited as an alarm message.

The alarm management device 30 may use an OPC, or may use an original standard other than the OPC. In a case where an OPC is used, the drive controlling units 10 and the alarm management device 30 transmit and receive data in accordance with a standard of the OPC. In a case where an original standard other than an OPC is used, the drive controlling units 10 and the alarm management device 30 transmit and receive data in accordance with the above-mentioned original standard.

The integrated monitoring device 40 is a device that acquires an alarm message transmitted from the alarm management device 30 so as to display the alarm message and/or a present alarm state. An operator is able to recognize a situation of whole of the plant controlling system 1 including an alarm message and/or a present alarm state from a displayed content that is displayed on the integrated monitoring device 40.

The engineering equipment 50 is a device that provides, to an engineer, a tool group for defining network definition information of various communication devices constituting the plant controlling system 1, the above-mentioned alarm definition information, and the like. The above-mentioned tool group includes a User Interface (UI) that defines pieces of definition information. The defined pieces of definition information are registered in an engineering Database (DB) 51 that is included in the engineering equipment 50.

### Conventional Problem

Incidentally, there has been presented a current situation that the plant network PN is designed depending on past experience and knowledge of engineers. Thus, there presents a problem that it is difficult to preliminarily recognize whether or not the design is appropriate. Moreover, there presents no useful tool for the above-mentioned preliminary recognition.

Additionally, in implementing a project for constructing and actually operating the plant network PN, the project has to be proceeded before a spec of the plant network PN is fixed, and thus there presents possibility that the spec is fixed or changed at the end of the project

Furthermore, in recent years, in order to streamline construction of the plant network PN, a project is increasing in which a network of the plant 2 is divided into parts by a modularization method and the divided parts are individually designed and verified to be shipped out, and further are integrated in a field. Similarly, in recent years, there presents a tendency that the number of communication devices to be considered in designing is increasing due to introduction of a so-called Open Process Architecture (OPA).

As a result, there presents possibility that a project has proceeded even if there potentially presents a problem that communication to be performed between communication devices, such as the drive controlling units 10 and the operation monitoring devices 20, exceeds communication capability of the communication devices, for example.

In such a case, the above-mentioned problem due to communication capability finally becomes tangible at a step of an actual-equipment test in the project in some cases, and thus needless backtracking work occurs due to design change and the like. In the worst case, there presents possibility of risk that products have been shipped out under a state where the problem remains intangible so as to start actual operation thereof, and the problem becomes tangible during the actual operation to lead to a serious plant accident.

Thus the network simulation method according to the embodiment is configured to include: acquiring communication information via communication or directly from a database in which the communication information related to communication devices constituting the plant network PN is defined; storing the acquired communication information; calculating, based on the stored communication information, a total communication amount of each of the communication devices supposed in communication executed in corresponding one of the communication devices; estimating, based on the total communication amount, an actual communication amount of each of the communication devices according to an arbitrary estimation condition specified by a user; determining at least presence/absence of a communication device whose actual communication amount exceeds communication capability of the communication device; and outputting a determined determination result to the user.

### Outlined Explanation of Present Embodiment

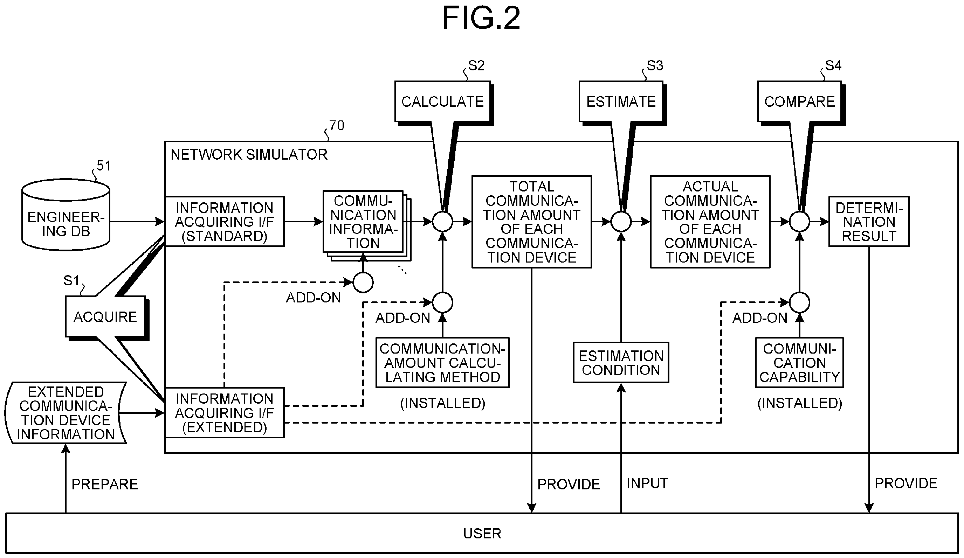

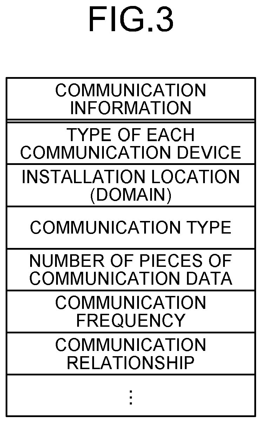

FIG. 2 is a diagram illustrating the outline of a network simulation method according to the embodiment. FIG. 3 is a diagram illustrating one example of communication information. As illustrated in FIG. 2, a network simulator 70 is used in a network simulation method according to the embodiment.

The network simulator 70 is a computer that executes a network simulation function to be mentioned later, and is used by an engineer (hereinafter, may be appropriately referred to as "user") that is in charge of design of the plant network PN, for example. The network simulator 70 is realized by, for example, a desktop PC, a laptop PC, a tablet terminal, a mobile telephone including a smartphone, a Personal Digital Assistant (PDA), and the like. The network simulator 70 may be realized as a wearable device that is worn by a user.

As illustrated in FIG. 2, the network simulator 70 includes a standard information acquiring Interface (I/F). The network simulator 70 acquires communication information of communication devices in the plant network PN via the above-mentioned standard information acquiring I/F from the above-mentioned engineering DB 51 of the engineering equipment 50 (Step S1). The communication information is information that is included in the above-mentioned network definition information.

As illustrated in FIG. 3, communication information includes, for example, a type of each communication device, an installation location (domain), a communication type, the number of pieces of communication data, a communication frequency, communication relationship, and the like. The communication type indicates a type of application communication executed by each communication device. For example, the above-mentioned type is difference among the above-mentioned graphic screen, the above-mentioned trend screen, and another application. The communication relation is information related to a communication object indicating that a target communication device is communicating with which of the other communication devices, for example. For example, in a case where a target communication device is a communication device A and the communication device A communicates with communication objects of communication devices B to D, the communication device A has communication relation (1) between the communication device A and the communication device B, (2) between the communication device A and the communication device C, and (3) between the communication device A and the communication device D; and all of these relations are defined in the communication information. A total communication amount of the communication device A is a value obtained by totaling communication amounts of the above-mentioned (1) to (3). In an input of an estimation condition to be mentioned later, individual selection of a communication detail, for example, the above-mentioned communication type and presence/absence of usage in each session, is possible for each of the communication relations of the above-mentioned (1) to (3). For example, a user is able to arbitrarily specify presence/absence of usage of a graphic screen between the communication device A and the communication device B. For example, in a case where a graphic screen is used between the communication device A and the communication device B, a user is able to arbitrarily specify the number thereof. For example, in a case where a graphic screen is used between the communication device A and the communication device B, a user is able to arbitrarily specify and adjust presence/absence of usage thereof for each graphic screen.

Returning to explanation with reference to FIG. 2. Note that a standard information acquiring I/F is a communication I/F, for example, and is realized by a Network Interface Card (NIC) and the like. The standard information acquiring I/F may be realized by, not limited to the communication I/F, a Universal Serial Bus (USB) that is directly connectable to peripheral equipment and the like. These points apply to an extended information acquiring I/F to be mentioned later.

The network simulator 70 calculates total communication amounts of respective communication devices on the basis of the acquired communication information and a communication-amount calculating method that is preliminarily installed in the network simulator 70 (Step S2). Note that the above-mentioned total communication amount is the theoretical maximum communication amount in communication executed in each communication device.

The network simulator 70 provides, to a user, the calculated total communication amount of each communication device. The user inputs an estimation condition with which he/her wants to execute simulation, on the basis of the provided total communication amount of each communication device. In the estimation condition, for example, the number of the above-mentioned graphic screens and trend screens and the like is able to be specified. Note that estimation condition may be reworded as a simulation condition.

The network simulator 70 selects, on the basis of the input estimation condition, presence/absence of usage of a communication type used in each communication device so as to estimate an actual communication amount of communication executed in the corresponding communication device (Step S3).

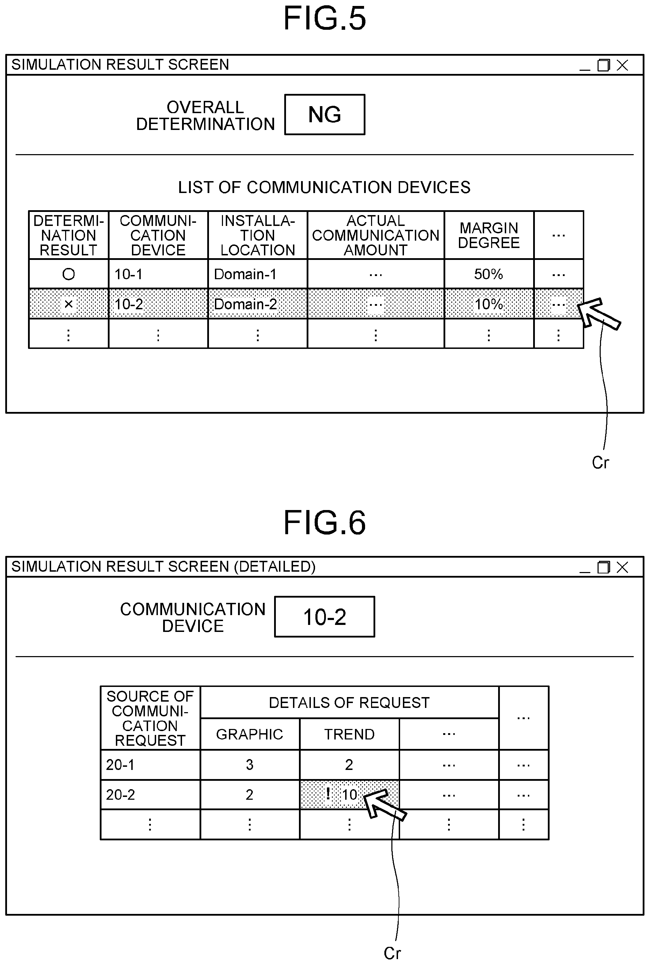

The network simulator 70 compares the estimated actual communication amount with communication capability of each communication device, which is preliminarily installed in the network simulator 70 (Step S4), and provide determination result, which is comparison result, to a user. The determination result includes presence/absence of a communication device in which communication exceeding communication capability thereof is executed, a margin degree of each communication device with respect to communication capability thereof, and the like. A displaying example of a simulation result screen that indicates such determination result will be mentioned later in explanation with reference to FIGS. 5 to 8.

Generally in a plant system, the plant network PN is constituted of communication devices of a plurality of vendors, all pieces of information that are needed for a simulation are not always known. As illustrated in FIG. 2, the network simulator 70 includes an extended information acquiring I/F with respect to the above-mentioned unknown information that is not already-known.

A user prepares extended communication device information as needed for information related to an unknown communication device such as another-vendor product, and causes the network simulator 70 to acquire the information via the extended information acquiring I/F (Step S1). The extended communication device information includes communication information, a communication-amount calculating method, communication capability, and the like to be able to reflect them on each of Steps S2, S3, and S4 as add-on information.

As described above, the network simulation method according to the embodiment is configured to include: acquiring communication information via communication or directly from a database in which the communication information related to communication devices constituting the plant network PN is defined; storing the acquired communication information; calculating, based on the stored communication information, a total communication amount of each of the communication devices supposed in communication executed in corresponding one of the communication devices; estimating, based on the total communication amount, an actual communication amount of each of the communication devices according to an arbitrary estimation condition specified by a user; determining at least presence/absence of a communication device whose actual communication amount exceeds communication capability of the communication device; and outputting a determined determination result to the user.

Therefore, in accordance with the network simulation method according to the embodiment, it is possible to effectively assist construction of the plant network PN. Hereinafter, a configuration example of the network simulator 70 according to the embodiment will be more specifically explained.

### Functional Configuration of Network Simulator

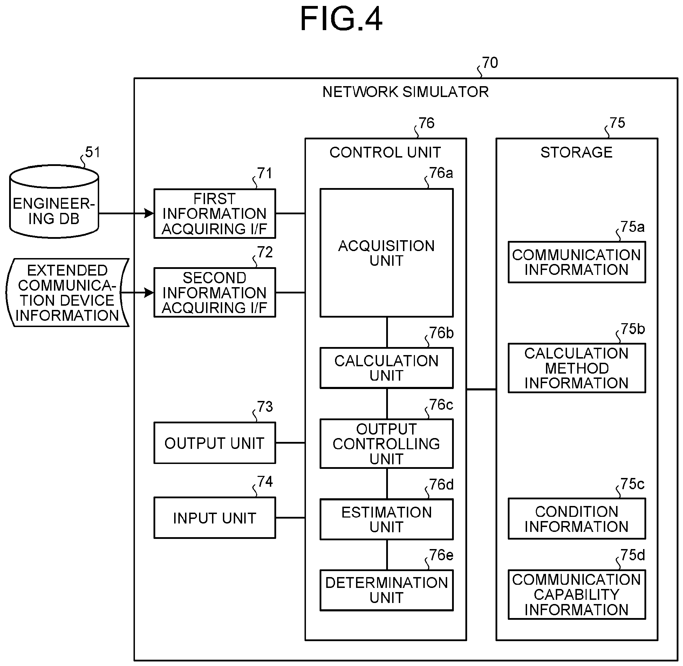

FIG. 4 is a block diagram illustrating a configuration example of the network simulator 70. Note that in FIG. 4, configuration elements alone that are needed for explanation of the present embodiment are illustrated, and description of general configuration elements is omitted.

As illustrated in FIG. 4, the network simulator 70 includes a first information acquiring I/F 71, a second information acquiring I/F 72, an output unit 73, an input unit 74, a storage 75, and a control unit 76.

The first information acquiring I/F 71 corresponds to the standard information acquiring I/F illustrated in FIG. 2. Similarly, the second information acquiring I/F 72 corresponds to the extended information acquiring I/F illustrated in FIG. 2.

The output unit 73 is realized by, for example, a display and the like so as to output a simulation result screen including a total communication amount of each communication device and an actual communication amount of each communication device under an arbitrary estimation condition.

The input unit 74 is realized by, for example, a keyboard, a mouse, and the like so as to receive various operations from a user, such as inputting of an estimation condition. The output unit 73 and the input unit 74 may be integrally constituted of a touch panel display and the like.

The storage 75 is realized by a semiconductor memory element such as a Random Access Memory (RAM) and a Flash Memory, or a storage such as a hard disk and an optical disk. In the example illustrated in FIG. 4, the storage 75 stores therein communication information 75a, calculation method information 75b, condition information 75c, and communication capability information 75d.

The communication information 75a has been already explained with reference to FIG. 3, and thus explanation thereof is omitted. The calculation method information 75b is information related to a calculation method of a communication amount in each communication device, and includes, for example, algorithm for calculating a communication amount in each communication device and/or a calculation model learned via machine learning, etc., and the like.

A calculation method related to an already-known communication device is able to be preliminarily installed in the calculation method information 75b. A calculation method related to an unknown communication device is able to be acquired as needed via the second information acquiring I/F 72, and further added to the calculation method information 75b.

An estimation condition that is input from a user via the input unit 74 is stored in the condition information 75c. The communication capability information 75d is information related to communication capability of each communication device. Communication capability of an already-known communication device is able to be preliminarily installed in the communication capability information 75d. Communication capability of an unknown communication device is able to be acquired as needed via the second information acquiring I/F 72, and further added to the communication capability information 75d.

The control unit 76 is a controller, for example, and is realized when a Central Processing Unit (CPU), a Micro Processing Unit (MPU), or the like executes, by using a RAM as a work region, various programs (not illustrated: corresponding to one example of network simulation program) stored in the storage 75. The control unit 76 is realized by an integrated circuit such as an Application Specific Integrated Circuit (ASIC) and a Field Programmable Gate Array (FPGA).

As illustrated in FIG. 4, the control unit 76 includes an acquisition unit 76a, a calculation unit 76b, an output controlling unit 76c, an estimation unit 76d, and a determination unit 76e so as to realize or execute functions and working of information processing to be mentioned later. Note that an inner configuration of the control unit 76 is not limited to that illustrated in FIG. 4; and may be another configuration as long as being capable of executing information processing to be mentioned later. Connection relation of processing units included in the control unit 76 is not limited to that illustrated in FIG. 4; and may be another connection relation.

The control unit 76 executes processes for realizing network simulation functions explained with reference to FIG. 2.

The acquisition unit 76a acquires communication information related to an already-known communication device from the engineering DB 51 via the first information acquiring I/F 71, and stores the acquired information in the communication information 75a. The acquisition unit 76a acquires communication information, a calculation method of a communication amount, and communication capability that are related to an unknown communication device from extended communication device information via the second information acquiring I/F 72, and respectively stores them in the communication information 75a, the calculation method information 75b, and the communication capability information 75d.

The calculation unit 76b calculates, on the basis of the communication information 75a and the calculation method information 75b, at least a total communication amount of each communication device that is the theoretical maximum communication amount in communication executed by the corresponding communication device. The calculation unit 76b calculates communication details of each communication device with respect to the above-mentioned corresponding total communication amount. Note that the calculation unit 76b may appropriately calculate various calculation values related to communication of each communication device in addition to the total communication amount and the communication details. A user selects presence/absence of usage of a communication detail used in each communication device and the like via the input unit 74 so as to adjust an estimation condition while recognizing the above-mentioned total communication amount, the above-mentioned communication details, and the like that are calculated by the calculation unit 76b.

The output controlling unit 76c executes output controlling for outputting, to the output unit 73, a calculation result calculated by the calculation unit 76b, namely, the above-mentioned total communication amount, the above-mentioned communication details, and the like. Specifically, the output controlling unit 76c generates an output screen in which the above-mentioned total communication amount, the above-mentioned communication details, and the like are laid out; and causes the output unit 73 to output the generated output screen. The output controlling unit 76c generates an output screen in which a simulation result is laid out which is a determination result to be mentioned later determined by the determination unit 76e, and executes output controlling for causing the output unit 73 to output the generated output screen.

When receiving provision of a calculation result from the calculation unit 76b, the estimation unit 76d receives an estimation condition that is input and adjusted by a user via the input unit 74, and stores the estimation condition in the condition information 75c. The estimation unit 76d selects, on the basis of the condition information 75c, presence/absence of usage of communication details used in each communication device; and estimates an actual communication amount of communication executed in the corresponding communication device.

The determination unit 76e compares an actual communication amount of each communication device which is estimated by the estimation unit 76d with communication capability of the corresponding communication device included in the communication capability information 75d, and determines whether or not the actual communication amount of the corresponding communication device exceeds communication capability of the corresponding communication device.

In a case where there presents a communication device whose actual communication amount exceeds communication capability thereof, the determination unit 76e determines that overall determination result is NG. In a case where there presents no communication device whose actual communication amount exceeds communication capability thereof, the determination unit 76e determines that overall determination result is OK.

The determination unit 76e calculates a margin degree of each communication device with respect to communication capability of the corresponding communication device itself and the like, and informs the output controlling unit 76c of the calculated margin degree and the like along with the determined overall determination result. The output controlling unit 76c generates, for example, a simulation result screen on the basis of various kinds of information reported from the determination unit 76e, and causes the output unit 73 to output the generated screen.

### Displaying Example of Simulation Result Screen

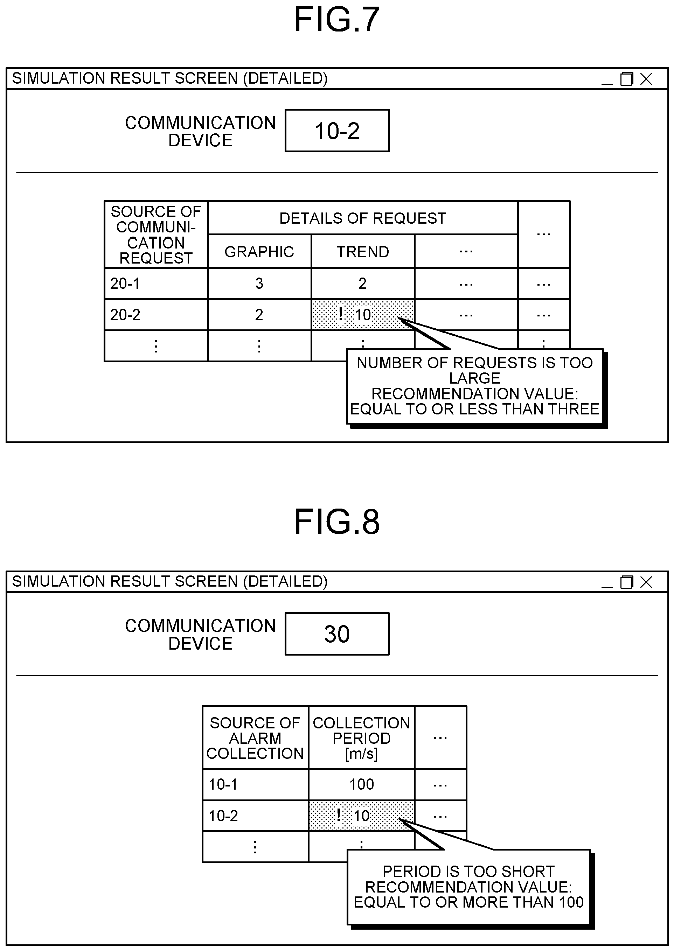

Next, a displaying example of a simulation result screen which the output controlling unit 76c causes the output unit 73 to display will be explained with reference to FIGS. 5 to 8. FIG. 5 is a diagram illustrating a displaying example of a simulation result screen. FIG. 6 is a diagram illustrating a displaying example of a simulation result screen. FIG. 7 is a diagram illustrating a displaying example of a simulation result screen. FIG. 8 is a diagram illustrating a displaying example of a simulation result screen.

As illustrated in FIG. 5, for example, the output controlling unit 76c causes the output unit 73 to display together, as a simulation result screen, overall determination result of whole simulation and a determination result of each communication device.

The example illustrated in FIG. 5 indicates that overall determination result is "NG". For example, a list of communication devices of simulation targets is displayed under the overall determination result, and there is indicated that determination result, a communication device, an installation location, an actual communication amount, a margin degree, and the like are displayed for each communication device.

As illustrated in FIG. 5, assume that determination result of a drive controlling unit 10-2 is NG (see "×" mark in FIG. 5). In this case, the output controlling unit 76c executes output controlling for displaying whole row corresponding to the drive controlling unit 10-2 in the list in a color that is different from a color of the other rows, for example, so as to clarify a communication device whose determination result is NG.

Assume that a user selects a row of the drive controlling unit 10-2 by using a cursor Cr. As illustrated in FIG. 6, the output controlling unit 76c causes to display a detailed simulation result screen related to the drive controlling unit 10-2, for example.

The example illustrated in FIG. 6 indicates that, as detailed simulation result, in communication executed by the drive controlling unit 10-2, there present communication requests for graphic screens, trend screens, and the like whose sources are operation monitoring devices 20-1 and 20-2, respectively.

In this case, as illustrated in FIG. 6, the output controlling unit 76c executes output controlling of, for example, displaying with emphasis (see "!" mark in FIG. 6) and the like so as to clarify a parameter value that is estimated not to be appropriate under an estimation condition.

Moreover, as illustrated in FIG. 7, in a case where the above-mentioned parameter value is selected by a user with the use of the cursor Cr, the output controlling unit 76c may execute output controlling for displaying guidance information in order to correct the corresponding parameter value and the like. The example illustrated in FIG. 7 indicates that guidance information is displayed, which indicates that the number of the corresponding requests is too large and a recommendation value is equal to or less than three. Thus, for example, communication executed between the drive controlling units 10 and the operation monitoring devices 20 is able to be optimized, so that it is possible to more effectively assist construction of the plant network PN.

Another example of such guidance information is illustrated in FIG. 8. As illustrated in FIG. 8, in communication executed by the alarm management device 30, assume that as detailed simulation result, a collection period parameter related to the drive controlling unit 10-2 is clarified not to be appropriate among collection periods whose alarm collection sources are drive controlling units 10-1 and 10-2.

In a case where the above-mentioned parameter value is selected by a user, as illustrated in FIG. 8, the output controlling unit 76c displays guidance information indicating that the corresponding period is too short and a recommendation value is equal to or more than 100, for example. Thus, for example, communication executed between the drive controlling units 10 and the alarm management device 30 is able to be optimized, so that it is possible to more effectively assist construction of the plant network PN.

Note that in FIG. 8, a collection period of an alarm is exemplified; however, the same applies to the number of alarm collection times per unit time and the like.

### Processing Procedure to be Executed by Network Simulator

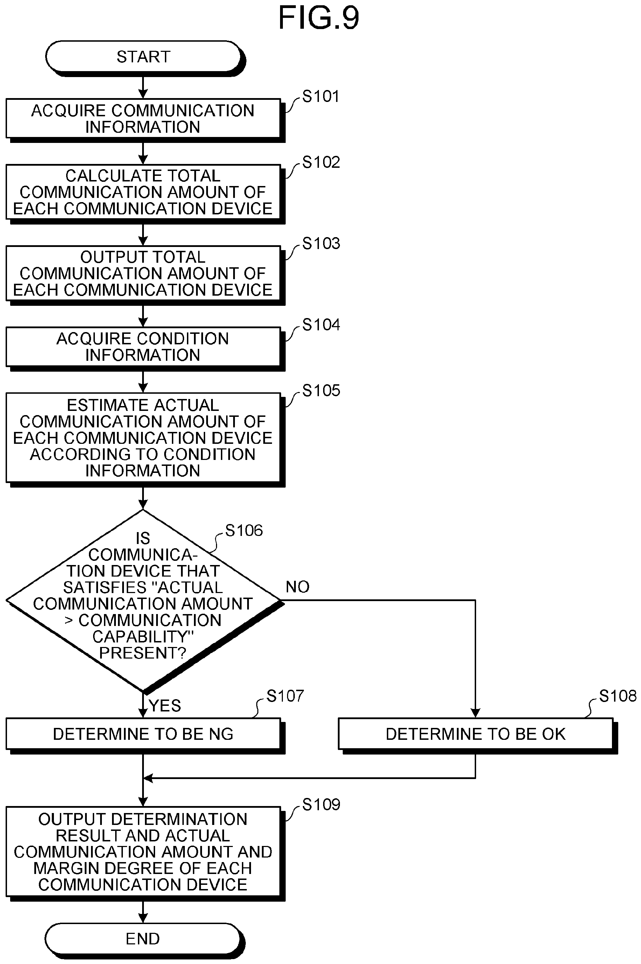

Next, a processing procedure to be executed by the network simulator 70 will be explained with reference to FIG. 9. FIG. 9 is a flowchart illustrating a processing procedure to be executed by the network simulator 70.

As illustrated in FIG. 9, the acquisition unit 76a acquires the communication information 75a (Step S101). The calculation unit 76b calculates, on the basis of the communication information 75a and the calculation method information 75b, a total communication amount of each communication device which is the theoretical maximum communication amount in communication executed by the corresponding communication device (Step S102).

The output controlling unit 76c outputs the total communication amount of each of the communication devices which is calculated by the calculation unit 76b (Step S103) .

Next, the estimation unit 76d acquires the condition information 75c that is input from a user via the input unit 74 (Step S104). The estimation unit 76d estimates an actual communication amount of each communication device according to the condition information 75c (Step S105).

The determination unit 76e compares the actual communication amount of each communication device which is estimated by the estimation unit 76d with communication capability of the corresponding communication device included in the communication capability information 75d, and determines presence/absence of a communication device whose actual communication amount exceeds communication capability thereof (Step S106).

Herein, in a case where there presents a communication device whose actual communication amount exceeds communication capability thereof (Step S106: Yes), the determination unit 76e determines that overall determination result of the simulation is NG (Step S107). In a case where there presents no communication device whose actual communication amount exceeds communication capability thereof (Step S106: No), the determination unit 76e determines that overall determination result of the simulation is OK (Step S108).

The output controlling unit 76c outputs the determination result by the determination unit 76e, and an actual communication amount and a margin degree of each communication device (Step S109); and ends the processing.

### Effects

As described above, the network simulator 70 according to the embodiment includes: the acquisition unit 76a that acquires the communication information 75a via communication or directly from the engineering DB 51 (corresponding to one example "database") in which the communication information related to communication devices constituting the plant network PN is defined; the storage 75 that stores therein the communication information 75a acquired by the acquisition unit 76a; the calculation unit 76b that calculates, based on the communication information 75a stored in the storage 75, a total communication amount of each of the communication devices supposed in communication executed in corresponding one of the communication devices; the estimation unit 76d that estimates, based on the total communication amount, an actual communication amount of each of the communication devices according to an arbitrary estimation condition specified by a user; the determination unit 76e that determines at least presence/absence of a communication device whose actual communication amount exceeds communication capability of the communication device; and the determination unit 76e that outputs a determination result determined by the determination unit to the user. Therefore, in accordance with the network simulator 70 according to the embodiment, it is possible to effectively assist construction of the plant network PN.

Specifically, it is possible to preliminarily and systematically recognize whether or not design of the plant network PN is appropriately executed. Moreover, it is possible not only to prevent backtracking work due to design error, but also to minimize effects due to unavoidable change in specification for implementing a project and the like. As a result, it is further possible to minimize a risk of extension of construction work and increase in cost due to increase in man-hours.

A simulation is executed in which a final network mode is supposed in executing division design of the plant network PN by using a modularization method, so that it is possible to implement a project in a short delivery period and with high quality even in a case of the large-scale plant network PN to which a great number of communication devices are connected. In other words, it is possible to realize implementation of a large-scale project with high efficiency and high quality.

Furthermore, it is possible to avoid a latent risk that a problem becomes tangible during actual operation to lead to a serious plant accident, so that it is further possible to contribute to stable operation of the plant 2.

The acquisition unit 76a acquires the communication information 75a related to an already-known communication device from the engineering equipment 50 including the engineering DB 51. Therefore, in accordance with the network simulator 70 according to the embodiment, it is possible to execute a precise simulation that is based on actual network definition information of the plant network PN.

The acquisition unit 76a is configured to be capable of extensionally acquiring the communication information 75a, a communication-amount calculating method, and the communication capability that are related to an unknown communication device. Therefore, in accordance with the network simulator 70 according to the embodiment, even in a case where unknown communication devices such as another-vendor products are added to the plant network PN, the communication information 75a of the above-mentioned communication devices are extensionally acquired, so that it is possible to execute precise simulation.

The communication information 75a include at least a communication type of each of the communication devices. The estimation unit 76d selects presence/absence of usage of a communication detail of each of the communication devices based on the estimation condition, and estimates the actual communication amount of communication executed in the corresponding communication device. Therefore, in accordance with the network simulator 70 according to the embodiment, it is possible to execute an appropriate simulation according to presence/absence of usage of a communication type such as a displaying screen and another application processing.

The determination unit 76e determines, in a case where there presents a communication device whose actual communication amount exceeds the communication capability of the communication device, that there presents an abnormality in communication of the plant network based on the estimation condition (namely, NG); and determines, in a case where there presents no communication device whose actual communication amount exceeds the communication capability of the communication device, that there presents no abnormality in communication of the plant network based on the estimation condition (namely, OK). Therefore, in accordance with the network simulator 70 according to the embodiment, it is possible to appropriately evaluate a specified content of an estimation condition, so that it is possible to reduce inherence of a problem in communication of the plant network PN.

The output controlling unit 76c outputs the determination result, the actual communication amount of each of the communication devices, and a margin degree of the corresponding communication device which is calculated by the determination unit 76e. Therefore, in accordance with the network simulator 70 according to the embodiment, it is possible to clarify a part in which a problem inheres in construction of the plant network PN so as to cause a user to immediately recognize the part.

The output controlling unit 76c outputs, based on the determination result, guidance information that urges the user to correct the estimation condition. Therefore, in accordance with the network simulator 70 according to the embodiment, it is possible to clarify a part in which a problem inheres in construction of the plant network PN so as to cause a user to appropriately correct the part.

### Other Embodiments

The embodiment according to the present disclosure has been explained, the present disclosure may be performed in various different modes in addition to the above-mentioned embodiment.

### Displaying Example and Others

The displayed layouts of the displaying examples and the like disclosed in the above-mentioned embodiment are merely examples, and may be arbitrarily changed.

### Determination of Total Communication Amount

In the above-mentioned embodiment, right or wrong of a total communication amount calculated by the calculation unit 76b may be determined. For example, in a case where a total communication amount calculated by the calculation unit 76b exceeds a predetermined reference value, guidance information that urges a user to reassess a configuration of the plant network PN may be reported without receiving an input of an estimation condition.

### Acquisition of Calculation Method Information and Communication Capability Information

In the above-mentioned embodiment, the calculation method information 75b and the communication capability information 75d are explained to be preliminarily installed in the network simulator 70; however, pieces of the information may be made into a database in an external device, and may be appropriately acquired as needed from the above-mentioned external device. The external device may be realized as a database managing device in the plant controlling system 1, for example, or may be realized as a cloud server that is accessible via the Internet and the like.

### System

Any of the processing procedures, the controlling procedures, the specific appellations, and the information including various data and parameters, which are described in the specification and the accompanying drawings, may be arbitrarily changed if not otherwise specified.

The illustrated components of the devices are functionally conceptual, and thus they are not to be physically configured as illustrated in the drawings. Specific forms of distribution and integration of the configuration elements of the illustrated devices are not limited to those illustrated in the drawings, and all or some of the devices can be configured by separating or integrating the apparatus functionally or physically in any unit, according to various types of loads, the status of use, etc.

Moreover, all or arbitrary part of the various processing functions, which are to be executed by each of the devices, may be executed by a CPU or a program that is analyzed and executed by the CPU, or may be realized as hardware by a wired logic.

### Hardware

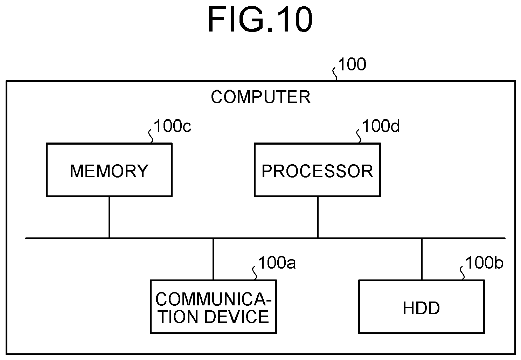

The drive controlling units 10, the operation monitoring devices 20, the alarm management device 30, the integrated monitoring device 40, the engineering equipment 50, and the network simulator 70 according to the above-mentioned embodiment are realized by a computer 100 having a configuration illustrated in FIG. 10, for example. Hereinafter, explanation will be described while exemplifying the network simulator 70. FIG. 10 is a diagram illustrating a hardware configuration of one example of the computer 100 configured to realize functions of the network simulator 70 according to the embodiment.

As illustrated in FIG. 10, the computer 100 includes a communication device 100a, a Hard Disk Drive (HDD) 100b, a memory 100c, and a processor 100d. The units illustrated in FIG. 10 are connected to each other by using a bus and the like.

The communication device 100a is an NIC or the like so as to communicate with another device. The HDD 100b stores therein programs and databases for operating functions illustrated in FIG. 4.

The processor 100d reads out a program that executes processes similar to the processing units illustrated in FIG. 4 from the HDD 100b and the like and expands the program into the memory 100c so as to cause a program that executes functions having described with reference to FIG. 4 and the like to operate. For example, the process executes functions similar to each processing unit included in the network simulator 70. Specifically, the processor 100d reads out, from the HDD 100b and the like, a program including functions similar to those of the acquisition unit 76a, the calculation unit 76b, the output controlling unit 76c, the estimation unit 76d, the determination unit 76e, and the like. The processor 100d executes a process for executing processes similar to those of the acquisition unit 76a, the calculation unit 76b, the output controlling unit 76c, the estimation unit 76d, the determination unit 76e, and the like.

As described above, the computer 100 reads out and executes a program so as to operate as an information processing apparatus that executes various processing methods. The computer 100 may read out the program from a recording medium by using a medium reading device, and executes the above-mentioned read program so as to realize functions similar to those according the above-mentioned embodiment. Note that the above-mentioned program is not limitedly executed by the computer 100 alone. For example, the present disclosure may similarly apply to a case where a computer or a server having another hardware configuration executes a program and a case where a computer and a server cooperate to execute a program.

The program may be distributed via a network such as the Internet. The program is recorded in a computer-readable recording medium such as a hard disk, a flexible disk (FD), a CD-ROM, a Magneto-Optical disk (MO), and a Digital Versatile Disc (DVD); and is read out from the recording medium by a computer to be executed.

## Claims

1. A network simulator (70) comprising:
an acquisition unit (76a) that acquires communication information (75a) via communication or directly from a database (51) in which the communication information related to communication devices constituting a plant network (PN) is defined;
a storage (75) that stores therein the communication information (75a) acquired by the acquisition unit (76a);
a calculation unit (76b) that calculates, based on the communication information (75a) stored in the storage (75), a total communication amount of each of the communication devices supposed in communication executed in corresponding one of the communication devices;
an estimation unit (76d) that estimates, based on the total communication amount, an actual communication amount of each of the communication devices according to an arbitrary estimation condition specified by a user;
a determination unit (76e) that determines at least presence/absence of a communication device whose actual communication amount exceeds communication capability of the communication device; and
an output controlling unit (76c) that outputs a determination result determined by the determination unit (76e) to the user.

2. The network simulator (70) according to claim 1, wherein
the acquisition unit (76a) acquires the communication information (75a) related to an already-known communication device from an engineering equipment including the database (51) .

3. The network simulator (70) according to claim 1 or 2, wherein
the acquisition unit (76a) is configured to be capable of extensionally acquiring the communication information (75a), a communication-amount calculating method, and the communication capability that are related to an unknown communication device.

4. The network simulator (70) according to any one of claims 1 to 3, wherein
the communication information (75a) include at least a communication type of each of the communication devices, and
the estimation unit (76d) selects presence/absence of usage of a communication detail of each of the communication devices based on the estimation condition, and estimates the actual communication amount of communication executed in the corresponding communication device.

5. The network simulator (70) according to any one of claims 1 to 4, wherein
the determination unit (76e) determines, in a case where there presents a communication device whose actual communication amount exceeds the communication capability of the communication device, that there presents an abnormality in communication of the plant network (PN) based on the estimation condition; and determines, in a case where there presents no communication device whose actual communication amount exceeds the communication capability of the communication device, that there presents no abnormality in communication of the plant network (PN) based on the estimation condition.

6. The network simulator (70) according to any one of claims 1 to 5, wherein
the output controlling unit (76c) outputs the determination result, the actual communication amount of each of the communication devices, and a margin degree of the corresponding communication device which is calculated by the determination unit (76e).

7. The network simulator (70) according to any one of claims 1 to 6, wherein
the output controlling unit (76c) outputs, based on the determination result, guidance information that urges the user to correct the estimation condition.

8. A network simulation method of a process executed by a computer, the process comprising:
acquiring communication information (75a) via communication or directly from a database (51) in which the communication information related to communication devices constituting a plant network (PN) is defined;
storing the acquired communication information (75a);
calculating, based on the stored communication information (75a), a total communication amount of each of the communication devices supposed in communication executed in corresponding one of the communication devices;
estimating, based on the total communication amount, an actual communication amount of each of the communication devices according to an arbitrary estimation condition specified by a user;
determining at least presence/absence of a communication device whose actual communication amount exceeds communication capability of the communication device; and
outputting a determined determination result to the user.

9. A network simulation program that causes a computer to execute a process comprising:
acquiring communication information (75a) via communication or directly from a database (51) in which the communication information related to communication devices constituting a plant network (PN) is defined;
storing the acquired communication information (75a);
calculating, based on the stored communication information (75a), a total communication amount of each of the communication devices supposed in communication executed in corresponding one of the communication devices;
estimating, based on the total communication amount, an actual communication amount of each of the communication devices according to an arbitrary estimation condition specified by a user;
determining at least presence/absence of a communication device whose actual communication amount exceeds communication capability of the communication device; and
outputting a determined determination result to the user.
